Europäisches Patentamt

European Patent Office

Office européen des brevets

(11) Publication number: 0 287 274
A2

# EUROPEAN PATENT APPLICATION

(21) Application number: 88303112.2

(22) Date of filing: 07.04.88

(51) Int. Cl.4: H05K 1/11 , H01R 9/09 , H01L 25/16

(30) Priority: 14.04.87 GB 8708904

(43) Date of publication of application:
19.10.88 Bulletin 88/42

(84) Designated Contracting States:
AT BE CH DE ES FR GR IT LI LU NL SE

(71) Applicant: PLESSEY OVERSEAS LIMITED
Vicarage Lane
Ilford Essex IGI 4AQ(GB)

(72) Inventor: Watts, David John
21, St.Georges Avenue
Northampton, NN2 6JR(GB)
Inventor: Yates, Christopher Llewellyn
16, Wantage Road
Northampton, NN1 4TH(GB)
Inventor: Mallett, William Barry
2, Rowan Close
Brackley Northats NN13 5UP(GB)

(74) Representative: Pritchard, Evan
Intellectual Property Department The
Plessey Company plc Vicarage Lane
Ilford Essex IG1 4AQ(GB)

(54) Semiconductor hybrid device.

(57) A semiconductor hybrid device comprising a ceramic substrate body 2 in the shape of a plane, which body 2 on a first side carries a thick film resistor arrangement 3 and on a second side supports a TTL logic device together with a capacitor, the device having a first set 7 of connection leads which are located in a plane parallel to the body plane and a second set 8 which are offset from said first set.

This allows the substrate 2 to be mounted vertically on a printed circuit board and thus it occupies only a minimum area of the board.

Fig.1

EP 0 287 274 A2

0 287 274

## SEMICONDUCTOR HYBRID DEVICE

This invention relates to a semiconductor hybrid device.

In the manufacture of electronic circuit boards, such as printed circuit boards, there is an ever increasing need to pack a greater number of components into a smaller area of the board. However, it is also required to facilitate the semi-automatic insertion of the components into the board so the components should not be too close together. The board has additionally to be capable of being reworked by hand during manufacture or later in order to permit a faulty component to be replaced in the event of a repair to the board being necessary.

The present invention was devised to economise on the space needed to mount components on a board and to enable the cost of manufacture of the board to be reduced.

According to the invention, there is provided a semiconductor hybrid device comprising a non-electrically conductive substrate body in the shape of a plane, which body on a first side carries a thick film resistor arrangement and on a second side supports a TTL logic device together with a capacitor, the device having a first set of connection leads which are located in a plane parallel to the plane of the body and a second set which are offset from said first set.

Preferably, one set of said connection leads lies in the plane of the substrate body. The leads may be arranged such that the offset leads are positioned alternatively with the leads of the other set along one side of the body.

In one embodiment, those components which are mounted on the substrate bofy such that they protrude a significant distance fromthe substrate surface, are located on the same side of the substrate as that towards which the offset leads are directed.

The resistor arrangement may comprise two or more resistors, one end of each resistor being connected to a common output connection lead.

The invention further comprises a printed circuit board including the aforementioned semiconductor hybrid device.

By way of example, a particular embodiment of the invention will now be described with reference to the accompanying drawing, in which:

Figure 1 and 2 are perspective views taken from both sides of the device, and,

Figure 3 is a cross-sectional view taken just inside one end of the device.

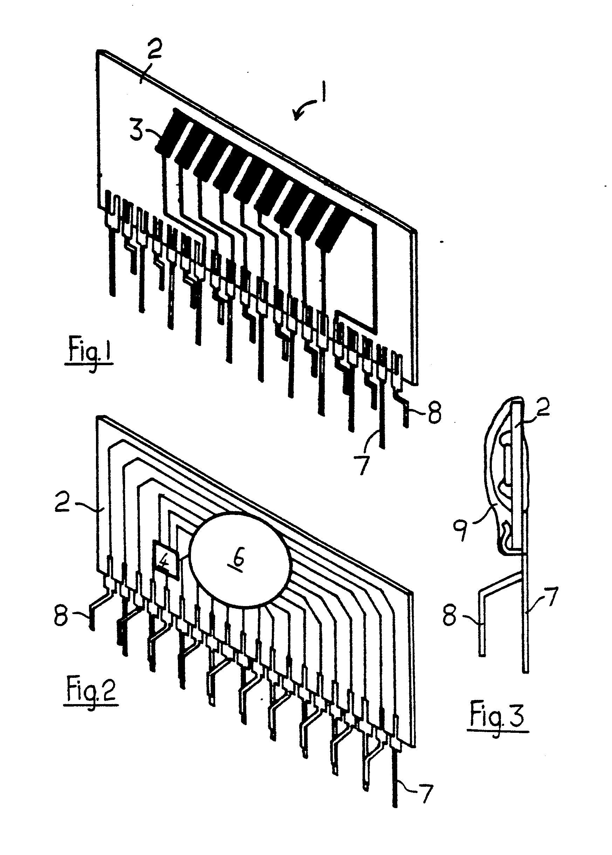

As depicted in Figures 1 and 2, the semiconductor hybrid device 1 has a substrate body 2 which is a small plate of a ceramic material. The body 2 carries on one side a thick film resistor arrangement 3 and on the opposite side a TTL logic device 4 and a capacitor 6.

The substrate body 2 also supports a total of twenty connection leads and these leads are of two kinds, a straight lead 7 being alternated with an offset lead 8 along the length of one side of the body. The purpose of the offset shape of the leads 8 is to enable the leads to be suitably spaced from one another when they are connected to the metallised areas on a printed circuit board.

The arrangement of the thick film resistors is one in which a number of resistor bodies is deposited on the surface of the body 2 with one end of each resistor being connected to a respective one of the connection leads 7, 8. The opposite end of every resistor is then connected to a common output lead and this common lead is joined to one of the connection leads 7, 8. By making electrical connections to a suitable pair of the connection leads 7, 8 a particular one of the resistor elements in the arrangement on the body 2 can thus be selected.

The electrical terminals of the TTL logic device and the capacitor on the opposite side of the body 2 are similarly connected to respective ones of the connection leads 7, 8.

It will be noticed that the components which protrude a significant distance from the board surface, are located on the same side of the board as that towards which the offset leads 8 are directed. This arrangement ensures tht the hybrid device will occupy only a minimum surface area when mounted on a printed circuit board.

After the electrical connections have been made, the substrate body 2 is given a coating 9 (Figure 3) of an electrically insulating material to provide external protection. This coating 9 is a dip coating in a phenolic medium coloured black. It acts to protect the hybrid device from contamination or damage.

In operation of the semiconductor hybrid device 1, the connection leads 7, 8 are pushed through suitable holes in a printed circuit board and the board upper surface then comes to rest in a position close to a bend in the offset leads 8. The portions of the connection leads 7, 8 which protrude through the lower side of the board can then be soldered in place and any excess length of the leads can be removed in the usual way.

2

The substrate body 2 is then seen to be maintained standing up in a plane normal to that of the board so that air is permitted to circulate freely round the hybrid device to allow effective cooling in operation. In addition, the device is able to occupy a much smaller area on the board than would be possible if it had been mounted in a plane parallel to the board plane. This area can be seen to be indeed rather small for a semiconductor device having twenty output leads and in a practical construction the dimensions of this area were 1.07 inches by 0.15 inches. This means that the device with its twenty leads was accommodated in an area of only 0.16 square inches on the board.

One reason for attempting to pack more components on a board is to increase the performance of the board thereby improving the performance of equipment in which the board is to be used.

A comparison of the areas (in square inches) occupied by the hybrid device of the invention and of Dual Inline and Leadless Devices is as follows:

| Type of Device | device dimensions | device area | typical areas resistor capacitor | | total area |
| --- | --- | --- | --- | --- | --- |
| Dual Inline | 1.07 x 0.30 | 0.321 | 0.15 | 0.045 | 0.516 |
| Leadless(a) | 0.56 x 0.56 | 0.314 | 0.15 | 0.045 | 0.509 |
| Leadless(b) | 0.60 x 0.60 | 0.360 | 0.15 | 0.045 | 0.555 |

this device has had 0.1 inches added to each side to allow access to the board if necessary for rework apparatus.

| Hybrid | 1.07 x 0.15 | 0.160 | - | - | 0.160 |
| --- | --- | --- | --- | --- | --- |

The dual inline and leadless devices require to have additional areas for a resistor pack and capacitor added to their basic board areas. The hybrid device of the invention already includes these components so the additions are not necessary.

If the average number of hybrid devices used on a board is ten, this can liberate a sufficient space on the board to allow twenty conventional components to be added to the board.

The construction of the present invention thus is accommodated in a package comprising logic device, capacitor and resistors and which occupies only a minimum part of the board area. This thus reduces the board area required to support these components and this can enable the overall cost of apparatus incorporating the semiconductor hybrid device to be reduced. The semiconductor hybrid device is also capable of being assembled on the board without the need for costly assembly equipment so this can lead to a further reduction in the overall cost of manufacturing the board.

The foregoing description of an embodiment of the invention has been given by way of example only and a number of modifications can be made without departing from the scope of the invention as defined in the appended claims. For instance, it is not essential that the device should accommodate only a single TTL logic device or a single capacitor. In different embodiments, more than one of these components could readily be incorporated.

In the embodiment described, the substrate body was of a ceramic material but the use of this material is not essential. Alternative materials could be used that were electrically non-conductive and were sufficiently rigid to permit handling without damage to the components supported thereon.

## Claims

1. A semiconductor hybrid device comprising a non-electrically conductive substrate body in the shape of a plane, which body on a first side carries a thick film resistor arrangement and on a second side supports a TTL logic device together with a capacitor, the device having a first set of connection leads which are located in a plane parallel to the plane of the body and a second set which are offset from said first set.

2. A device as claimed in Claim 1, in which one set of said connection leads lies in the plane of said substrate body.

3. A device as claimed in Claim 1 or 2, in which the leads are arranged such that the offset leads are positioned alternately with the leads of the other set along one side of the body.

4. A device as claimed in any one of Claims 1 to 3, in which those components which are mounted on the substrate body such that they protrude a significant distance from the substrate surface, are located on the same side of the substrate as that towards which the offset leads are directed.

5. A device as claimed in any one of Claims 1 to 3, in which the resistor arrangement comprises two or more resistors, one end of each resistor being connected to a common output lead.

6. A device as claimed in any one of Claims 1 to 4, in which the substrate body together with the components supported thereon is provided with an electrically insulating surface coating.

7. A semiconductor hybrid device substantially as hereinbefore described with reference to the accompanying drawing.

8. A printed circuit board including a semiconductor hybrid device as claimed in any one of Claims 1 to 6.

88303112.2

Fig.1

Fig.2

Fig.3